# EUROPÄISCHE PATENTSCHRIFT

(11) **EP 0 461 282 B1**
(45) Veröffentlichungstag und Bekanntmachung des Hinweises auf die Patenterteilung: **21.12.1994**
(21) Anmeldenummer: 90111111.2
(22) Anmeldetag: 12.06.1990
(51) Int. Cl.: H03M 3/02

(54) **Überabtastender Analog-Digital-Umsetzer mit Rauschfilterung in Switched-Capacitor-Technik**
Oversampling analog/digital converter with noise shaping in switched capacitor techniques
Convertisseur analogique numérique à suréchantillonnage avec filtrage de bruit en technique de capacités commutée

(43) Veröffentlichungstag der Anmeldung: 18.12.1991
(73) Patentinhaber: SIEMENS AKTIENGESELLSCHAFT, 80333 München (DE)
(72) Erfinder: Brückmann, Dieter, Dr. Ing., D-4000 Düsseldorf (DE)

(56) Entgegenhaltungen:
- EP-A- 0 325 926
- IEEE JOURNAL OF SOLID-STATE CIRCUITS. vol. sc-22, no. 6, Dezember 1987, NEW YORK US Seiten 921 - 929; y. Matsuya et al:: "A 16-bit Oversampling A-to-D Conversion Technology Using Triple-Integration Noise Shaping"
- IEEE TRANSACTIONS ON CIRCUITS AND SYSTEMS. vol. cas34, no. 5, Mai 1987, NEW YORK US Seiten 571 - 574; K. Nagaraj et al.: "Switched-Capacitor Circuits with Reduced Sensitivity to Amplifier Gain"
- IEEE JOURNAL OF SOLID-STATE CIRCUITS. vol. sc-22, no. 6, Dezember 1987, NEW YORK US Seiten 971 - 981; L. E. Larson: "GaAs Switched-Capacitor Circuits for High-Speed-Signal Processing"

## Beschreibung

Die Erfindung betrifft einen überabtastenden Analog-Digital-Umsetzer mit Rauschfilterung in Switched-Capacitor-Technik.

Die Realisierung hochauflösender und hochlinearer Analog-Digital-Umsetzer mit Widerstands-, Transistor- oder Kondensatornetzwerken ist derzeit nur mit irgendeiner Form von Abgleich oder Korrektur möglich. Für manche Anwendungsfälle stellen daher Analog-Digital-Umsetzer mit Überabtastung und Rauschfilterung eine praktikable Lösung dar. Dabei wird mit einer höheren Abtastrate, als aufgrund des Nyquist-Theorems erforderlich ist, und mit einer geringen Auflösung gearbeitet. In einem nachfolgenden digitalen, also im wesentlichen unkritischen Filter, wird dann aus dem hochfrequenten Signal geringer Auflösung ein niederfrequentes Signal hoher Auflösung gewonnen. Durch die Überabtastung verteilt sich das gesamte Quantisierungsrauschen über einen größeren Frequenzbereich, wodurch sich das Rauschen im Signalbandbereich verringert. Bei der Rauschfilterung wird ein Teil des Quantisierungsrauschens aus dem Signalband in andere Frequenzbereiche verschoben, so daß sich der Signal-Geräusch-Abstand im Signalband weiterhin verbessert.

Für die Rauschfilterung benutzt man im allgemeinen Integratorschaltungen, wobei sich mit steigender Ordnung des Integrators der Signal-Geräusch-Abstand verbessert. Übliche Integratorschaltungen dritter und höherer Ordnung sind jedoch im wesentlichen nicht stabil. Aus Yasuyuki Matsuya, Kuniharu Uchimura, Atsushi Iwata, Tsutomu Kobayashi, Masayuki Ishikawa und Takeshi Yoshitome, 16-Bit Oversampling A-to-D Conversion Technology Using Triple-Integration Noise Shaping, IEEE Journal of Solid-State Circuits, Band SC-22, No. 6, Seite 921-929, December 1978, ist bekannt, Analog-Digital-Wandler mit Überabtastung und Rauschfilterung dritter Ordnung durch Kaskadenschaltung von drei Umsetzern erster Ordnung, d.h. auch von Integratoren erster Ordnung, zu bilden. Bei diesen Analog-Digital-Umsetzern treten keinerlei Stabilitätsprobleme auf.

Um die Unempfindlichkeit gegenüber Parameterschwankungen noch zu erhöhen, wird der bekannte Analog-Digital-Umsetzer nicht mit RC-Gliedern zur Bestimmung der Zeitkonstanten, beispielsweise der Integratorzeitkonstanten, realisiert, sondern in Switched-Capacitor-Technik. Dabei sind die Zeitkonstanten nicht mehr von der absoluten Größe eines Widerstandes R und eines Kondensators C abhängig, sondern von den wesentlich geringeren Schwankungen unterworfenen Verhältnis zweier Kondensatoren. Bei Analog-Digital-Umsetzern mit Überabtastung wird prinzipgemäß mit einer hohen Taktfrequenz gearbeitet. Die Bandbreite der Integratoren bzw. der dabei verwendeten Operationsverstärker sollte wiederum einen bestimmten Faktor über dieser Taktfrequenz liegen, um ein hinreichend genaues Einschwingen der Integratoren bzw. der Operationsverstärker während jeder Taktperiode zu gewährleisten. Damit muß die Bandbreite der Integratoren bzw. der Operationsverstärker erheblich höher liegen als die höchste zu verarbeitende Frequenz. Darüber hinaus wird aber auch eine hohe Leerlaufverstärkung gefordert, um einen bei diesem Umsetzer auftretenden Kompensationseffekt, der zu einer Verminderung des Quantisierungsgeräuschs führt, zu erzielen. Hohe Verstärkungsfaktoren, insbesondere bei integrierten CMOS-Operationsverstärkern lassen sich nur durch einen sehr hohen Realisierungsaufwand und auf Kosten der Geschwindigkeit und damit auf Kosten der Bandbreite der Operationsverstärker erreichen. Um die Anforderungen an die Operationsverstärker bei dem bekannten Analog-Digital-Umsetzer gering zu halten, wurde bei den Integratoren das Kapazitätsverhältnis der beiden zugehörigen Kondensatoren vergrößert. Damit wird jedoch der Aussteuerungsbereich des Analog-Digital-Umsetzers eingeschränkt.

Aus K. Nagaraj, T. R. Viswanathan, K. Singhal und J. Vlach, Switched-Capacitor Circuits with Reduced Sensitivity to Amplifier Gain, IEEE Transactions on Circuits and Systems, Bd. CAS-34, No. 5, May 1987, S. 571-574, ist ein Integrator in Switched-Capacitor-Technik bekannt, bei dem die Empfindlichkeit gegenüber den Einflüssen der endlichen Leerlaufverstärkung der Operationsverstärker stark reduziert ist. Bei diesem Integrator wird in beiden Taktphasen die Eingangsspannung abwechselnd auf jeweils einem Kondensator, nämlich auf einem ersten oder zweiten Kondensator, abgespeichert. In jeder zweiten Phase erfolgt dann bereits ein Integrationsschritt und der erste Kondensator wird über einen dritten Kondensator entladen. Verursacht durch die endliche Leerlaufverstärkung des Operationsverstärkers treten an dessen Eingängen Offset-Spannungen und Offset-Ströme auf, die ein vollständiges Entladen des ersten Kondensators verhindern, so daß dieser Integrationsschritt verlustbehaftet ist. Deshalb wird die zwischen den Eingängen des Operationsverstärkers auftretende Spannung gleichzeitig auf einem vierten Kondensator abgespeichert. In der darauffolgenden Taktphase erfolgt dann der eigentliche Integrationsschritt, d.h. der zweite Kondensator wird über einen fünften Kondensator entladen. Dabei wird der zweite Kondensator nicht direkt, sondern über den vierten Kondensator mit dem negativen Eingang des Operationsverstärkers verbunden. Die Offset-Spannung am Eingang des Operationsverstärkers wird somit kompensiert, so daß eine vollständige Entladung des zweiten Kondensators erfolgt. Die Schaltung verhält sich also so, als ob der Operationsverstärker eine unendliche Leerlaufverstärkung hätte.

Aufgabe der Erfindung ist es, den bekannten Integrator und den bekannten Analog-Digital-Umsetzer mit Überabtastung und Rauschfilterung derart abzuändern, daß eine Kombination beider möglich ist. Diese Aufgabe wird durch einen Analog-Digital-Umsetzer gemäß Patentanspruch 1 gelöst. Eine Weiterbildung des Erfindungsgedankens ist in einem Unteranspruch gekennzeichnet.

Vorteile eines erfindungsgemäßen Analog-Digital-Umsetzers sind eine hohe Stabilität, ein geringer schaltungstechnischer Aufwand, eine geringe Empfindlichkeit gegenüber Bauteileschwankungen und externen Störeinflüssen sowie ein größerer Aussteuerungsbereich.

Die Erfindung wird nachfolgend anhand des in den Figuren der Zeichnung dargestellten Ausführungsbeispiels näher erläutert. Es zeigt:
- Figur 1: eine Ausführungsform eines erfindungsgemäßen Analog-Digital-Umsetzers mit Überabtastung und Rauschfilterung in Switched-Capacitor-Technik in einem Blockschaltbild,
- Figur 2: eine erfindungsgemäße Umsetzerstufe bei einem Analog-Digital-Umsetzer nach Figur 1, und
- Figur 3: das Taktschema eines Analog-Digital-Umsetzers nach Figur 1.

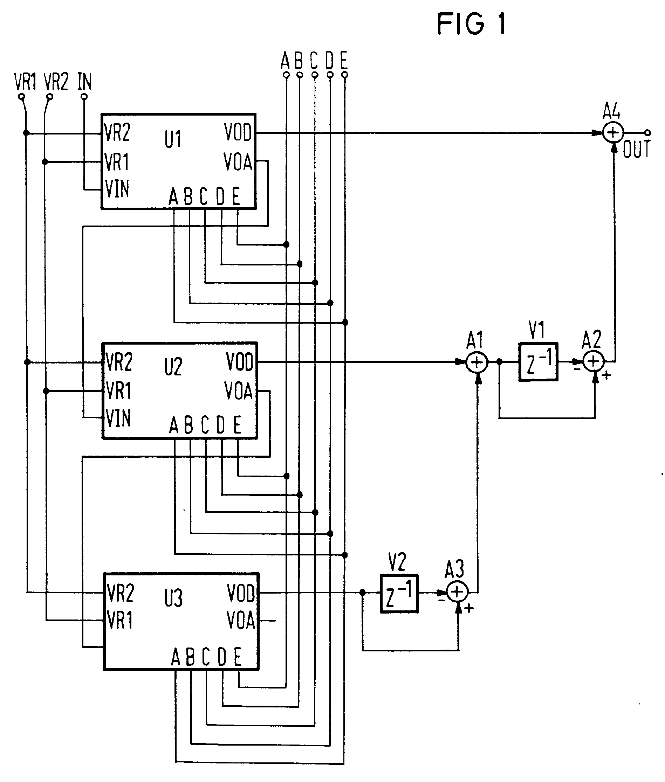

Das Ausführungsbeispiel nach Figur 1 zeigt einen Analog-Digital-Umsetzer mit Überabtastung und Rauschfilterung dritter Ordnung, der aus drei identisch aufgebauten Umsetzerstufen U1, U2, U3 von jeweils erster Ordnung besteht. An jede der drei Umsetzerstufen U1, U2, U3 sind zwei Referenzpotentiale VR1, VR2 und fünf Taktsignale A, B, C, D, E angelegt. Als Eingangssignal ist bei der Umsetzerstufe U1 das Eingangssignal IN des Analog-Digital-Umsetzers, bei der Umsetzerstufe U2 ein Ausgangssignal VOA der Umsetzerstufe U1 und bei der Umsetzerstufe U3 ein Ausgangssignal VOA der Umsetzerstufe U2 vorgesehen. Ein Ausgangssignal VOD der Umsetzerstufe U3 ist zum einen an den Eingang eines Verzögerungselementes V2 und zum anderen an einen Eingang eines Addierers A3 gelegt, dessen anderer Eingang mit dem Ausgang des Verzögerungselementes V2 verbunden ist. Der Ausgang des Addierers A3 ist auf einen Eingang eines Addierers A1 geführt, dessen anderer Eingang mit einem Ausgangssignal VOD der Umsetzerstufe U2 angesteuert wird. Der Ausgang des Addierers A1 ist zum einen mit dem Eingang eines Verzögerungselementes V1 und zum anderen mit einem Eingang eines Addierers A2 verbunden, dessen anderer Eingang an den Ausgang des Verzögerungselementes V1 angeschlossen ist. Das Ausgangssignal eines Addierers A4, dessen einer Eingang mit dem Ausgang des Addierers A2 verschaltet ist und an dessen anderen Eingang ein Ausgangssignal VOD der Umsetzerstufe U1 angelegt ist ist als Ausgangssignal OUT des Analog-Digital-Umsetzers vorgesehen. Das Verzögerungselement V1 in Verbindung mit dem Addierer A2 bzw. das Verzögerungselement V2 in Verbindung mit Addierer A3 bilden jeweils digitale Differenzierstufen. Die Differenzierstufen sind beim gezeigten Ausführungsbeispiel so geschaltet, daß digitale Ausgangssignale VOD führende Ausgänge benachbarter Umsetzerstufen U1, U2, U3 über jeweils eine Differenzierstufe derart miteinander gekoppelt sind, daß jeweils das Ausgangssignal einer Differenzierstufe mit dem digitalen Ausgangssignal VOD eine Umsetzerstufe U1, U2, U3 addiert und der jeweils nachfolgenden Differenzierstufe zugeführt wird. Der Vorteil gegenüber Ausgestaltungen, bei denen die digitalen Ausgangssignale VOD der Umsetzerstufen U1, U2, U3 über jeweils eine entsprechende Anzahl von Differenzierstufen geführt und dann aufsummiert werden, wobei die Anzahl gleich der jeweils vorgeschalteten Umsetzerstufen ist, liegt darin, daß sich die Gesamtzahl der Differenzierstufen und damit der schaltungstechnische Aufwand verringert, insbesondere da auch die Addierer A1 und A3 bzw. A2 und A4 bei entsprechender Ausführung auch zu jeweils einem Addierer zusammengefaßt werden können.

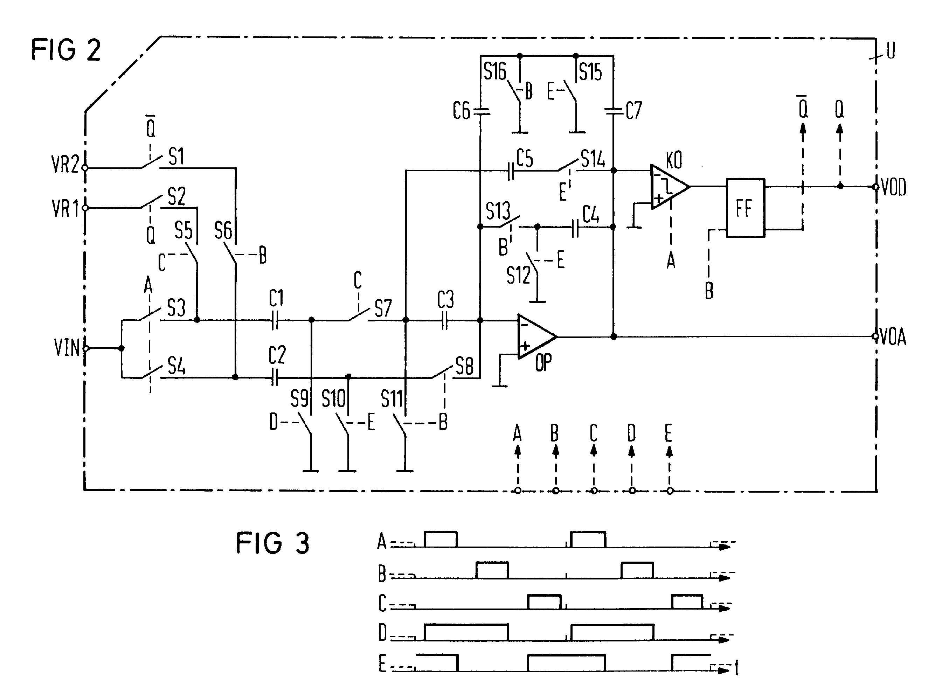

Die Umsetzerstufen U1, U2, U3 sind dabei identisch aufgebaut. Ein Ausführungsbeispiel einer derartigen Umsetzerstufe U in Switched-Capacitor-Technik zeigt Figur 2 der Zeichnung. Das Eingangssignal VIN ist zum einen über einen steuerbaren elektronischen Schalter S3 auf einen Anschluß eines Kondensators C1 und zum anderen über einen steuerbaren elektronischen Schalter S4 auf einen Anschluß eines Kondensators C2 geführt. An den einen Anschluß des Kondensators C1 ist zudem über einen steuerbaren elektronischen Schalter S2 und einen steuerbaren elektronischen Schalter S5 in Reihe das Referenzpotential VR1 aufschaltbar. Entsprechend ist auf den einen Anschluß des Kondensators C2 über einen steuerbaren elektronischen Schalter S1 und einen steuerbaren elektronischen Schalter S6 in Reihe das Referenzpotential VR2 aufschaltbar. Zwischen dem anderen Anschluß des Kondensators C1 und einem Anschluß eines Kondensators C3 ist ein steuerbarer elektronischer Schalter S7 und zwischen dem anderen Anschluß des Kondensators C2 und dem anderen Anschluß des Kondensators C3 ist ein steuerbarer elektronischer Schalter S8 geschaltet. Zudem sind der andere Anschluß des Kondensators C1, der andere Anschluß des Kondensators C2 und der eine Anschluß des Kondensators C3 über jeweils einen steuerbaren elektronischen Schalter S9, S10 bzw. S11 auf Bezugspotential aufschaltbar. Der andere Anschluß des Kondensators C3 ist mit dem invertierenden Eingang eines Operationsverstärkers OP verbunden, dessen nichtinvertierender Eingang auf Bezugspotential liegt und dessen Ausgang das Ausgangssignal VOA führt. Zwischen den Ausgang des Operationsverstärkers OP und seinem invertierenden Eingang ist ein Rückkopplungsnetzwerk geschaltet. Dieses besteht aus einem Kondensator C4, dessen einer Anschluß über einen steuerbaren elektronischen Schalter S12 auf Bezugspotential und über einen steuerbaren elektronischen Schalter S13 auf den invertierenden Eingang aufschaltbar ist und dessen anderer Anschluß mit dem Ausgang des Operationsverstärkers OP verbunden ist. Schließlich ist der Ausgang des Operationsverstärkers OP über eine Reihenschaltung aus einem Kondensator C5 und einem steuerbaren elektronischen Schalter S14 mit dem einen Anschluß des Kondensators C3 verbunden. Diesem Rückkopplungsnetzwerk ist in Ausgestaltung der Erfindung ein weiteres Rückkopplungsnetzwerk parallelgeschaltet. Dieses weist eine Reihenschaltung aus zwei Kondensatoren C6 und C7 zwischen invertierendem Eingang und Ausgang des Operationsverstärkers OP auf. Die miteinander verbundenen Anschlüsse der Kondensatoren C6 und C7 sind darüber hinaus über jeweils einen steuerbaren elektronischen Schalter S15 bzw. S16 auf Bezugspotential aufschaltbar. Das zusätzliche Rückkopplungsnetzwerk verhindert, daß der Operationsverstärker OP zwischen den Schaltphasen der steuerbaren elektronischen Schalter S12, S13, S14 nicht rückgekoppelt und daher instabil ist. Das Ausgangssignal VOA ist auf den invertierenden Eingang eines Komparators KO geführt, dessen nichtinvertierender Eingang auf Bezugspotential liegt und an dessen Ausgang ein als Speicherelement vorgesehenes Flip-Flop FF angeschlossen ist. Der invertierte und nichtinvertierte Ausgang des Flip-Flops FF führen jeweils Taktsignale Q̅ bzw. Q, wobei das Taktsignal Q auch als Ausgangssignal VOD vorgesehen ist.

Die Taktsignale Q, Q̅ dienen ebenso wie die Taktsignale A, B, C, D, E zur Steuerung der elektronischen Schalter S1 bis S16. Dabei sind zur Steuerung der elektronischen Schalter S3 und S4 sowie des Komparators KO das Taktsignal A, zur Steuerung der elektronischen Schalter S6, S8, S11, S13, S16 sowie des Flip-Flops FF das Taktsignal B, zur Steuerung der elektronischen Schalter S5 und S7 das Taktsignal C, zur Steuerung des elektronischen Schalters S9 das Taktsignal D und zur Steuerung der elektronischen Schalter S10, S12, S14 und S15 das Taktsignal E vorgesehen. Der elektronische Schalter S1 wird dabei durch das Taktsignal Q̅ und der elektronische Schalter S2 durch das Taktsignal Q gesteuert.

Den Verlauf der Taktsignale A, B, C, D und E über der Zeit t zeigt Figur 3. Diese Taktsignale sind periodisch, d.h., daß Impulse von bestimmter Dauer in bestimmten Zeitabständen wiederkehrend auftreten. Die Taktsignale A, B und C sind dabei zeitlich zueinander derart angeordnet, daß zunächst ein Impuls beim Taktsignal A, daran anschließend ein Impuls beim Taktsignal B und wiederum daran anschließend ein Impuls beim Taktsignal C auftritt. Danach tritt wiederum bei Taktsignal A ein Impuls auf usw., wobei die Taktsignale A, B und C nicht überlappend ausgebildet sind, d.h., daß erst nach dem Abklingen des Impulses bei einem Taktsignal der Anstieg des Impulses beim anderen Taktsignal erfolgt. Durch nichtüberlappende Taktsignale A, B, C wird ein Einfluß der endlichen Schaltzeiten der elektronischen Schalter auf das Verhalten des Analog-Digital-Umsetzers eliminiert. Beim Taktsignal D wird ein Impuls abgegeben, der gleichzeitig mit dem Impuls des Taktsignals A beginnt und gleichzeitig mit dem Impuls des Taktsignals B endet. Beim Taktsignal E wird schließlich ein Impuls abgegeben, der gleichzeitig mit dem Impuls des Taktsignales C beginnt und gleichzeitig mit dem Impuls des Taktsignales A endet. Für die Taktsignale Q und Q̅ ist hierzu keine genaue zeitliche Zuordnung anzugeben, da diese Taktsignale auch vom Eingangssignal VIN abhängen.

Abschließend sei darauf hingewiesen, daß durch Hinzuschalten weiterer Umsetzerstufen und zugehöriger Differenzierstufen stabile überabtastende Analog-Digital-Umsetzer höherer Ordnung realisiert werden können.

## Patentansprüche

1. Überabtastender Analog-Digital-Umsetzer mit mindestens drei mit jeweils einem analogen Eingangssignal (VIN) angesteuerten und jeweils ein analoges sowie ein digitales Ausgangssignal (VOA; VOD, Q) abgebenden, identisch aufgebauten Umsetzerstufen (U1, U2, U3),
bei dem die Umsetzerstufen (U1, U2, U3) bezüglich der analogen Eingangs- und Ausgangssignale (VIN, VOA) in Reihe geschaltet sind,
bei dem die digitalen Ausgangssignale (VOD) der Umsetzerstufen (U1, U2, U3) über jeweils eine Anzahl von in Reihe geschalteten Differenzierstufen (V1, V2, A2, A3), die gleich der Anzahl der den jeweilis vorgeschalteten Umsetzerstufen (U1,U2) ist, geführt und aufsummiert werden,
bei dem die Umsetzerstufen (U1, U2, U3) jeweils einen Operationsverstärker (OP), an dessen Ausgang das analoge Ausgangssignal (VOA) der jeweiligen Umsetzerstufe (U1, U2, U3) anliegt, einen dem Operationsverstärker (OP) nachgeschalteten Komparator (KO) und ein dem Komparator (KO) nachgeschaltetes Speicherelement (FF), an dessen Ausgang das digitale Ausgangssignal (VOD) der jeweiligen Umsetzerstufe (U1, U2, U3) anliegt, aufweisen,
bei dem in den Umsetzerstufen (U1, U2, U3) jeweils das analoge Eingangssignal (VIN) zum einen über einen ersten steuerbaren Schalter (S3) auf einen Anschluß eines ersten Kondensators (C1), an dem zudem über einen zweiten und dritten steuerbaren Schalter (S2, S5) in Reihe ein erstes Referenzpotential (VR1) aufschaltbar ist, und zum anderen über einen vierten steuerbaren Schalter (S4) auf einen Anschluß eines zweiten Kondensators (C2), an dem zudem über einen fünften und sechsten steuerbaren Schalter (S1, S6) ein zweites Referenzpotential (VR2) aufschaltbar ist, geführt wird,
bei dem in den Umsetzerstufen (U1, U2, U3) jeweils der andere Anschluß des zweiten Kondensators (C1) zum einen über einen siebten steuerbaren Schalter (S9) an ein Bezugspotential und zum anderen über einen achten steuerbaren Schalter (S7) an einem auf das Bezugspotential führenden neunten steuerbaren Schalter (S11) sowie an einem Anschluß eines dritten Kondensators (C3), dessen anderer Anschluß mit einem invertierenden Eingang des Operationsverstärkers (OP) verbunden ist, angeschlossen ist,
bei dem in den Umsetzerstufen (U1, U2, U3) jeweils der andere Anschluß des zweiten Kondensators (C2) zum einen über einen zehnten steuerbaren Schalter (S10) an das Bezugspotential und zum anderen über einen elften steuerbaren Schalter (S8) an den invertierenden Eingang des Operationsverstärkers (OP) angeschlossen ist, bei dem in den Umsetzerstufen (U1, U2, U3) jeweils der Ausgang des Operationsverstärkers (OP) zum einen über einen zwölften steuerbaren Schalter (S14) sowie einem vierten Kondensator (C5) in Reihe an den einen Anschluß des dritten Kondensators (C3) und zum anderen über einen fünften Kondensator (C4) an einem auf das Bezugspotential führenden dreizehnten steuerbaren Schalter (S12) sowie an einem mit dem invertierenden Eingang des Operationsverstärkers (OP) verschalteten vierzehnten steuerbaren Schalter (S13) angeschlossen ist,
bei dem in den Umsetzerstufen (U1, U2, U3) der erste und vierte Schalter (S3, S4) durch ein erstes Taktsignal (A), der sechste, neunte, elfte und vierzehnte Schalter (S6, S11, S8, S13) durch ein zweites Taktsignal (B), der dritte und achte Schalter (S5, S7) durch ein drittes Taktsignal (C), der siebte Schalter (S9) durch ein viertes Taktsignal (D), der zehnte, zwölfte und dreizehnte Schalter (S10, S12, S14) durch ein fünftes Taktsignal (E), der fünfte Schalter (S1) durch das invertierte digitale Ausgangssignal (Q̅) und der zweite Schalter (S2) durch das digitale Ausgangssignal (Q) gesteuert werden,
bei dem als erstes, zweites und drittes Taktsignal (A, B, C) nacheinander auftretende, zyklisch wiederkehrende und das Durchschalten der jeweils zugeordneten Schalter bewirkende Impulse und als viertes und fünftes Taktsignal (D, E) das Durchschalten der jeweils zugeordneten Schalter bewirkende Impulse, die mit dem Impuls des ersten Taktsignals (A) beginnen und mit dem Impuls des zweiten Taktsignals (B) enden bzw. die mit dem Impuls des dritten Taktsignals (C) beginnen und mit dem Impuls des ersten Taktsignals (A) enden, vorgesehen sind.

2. Analog-Digital-Umsetzer nach Anspruch 1,
**dadurch gekennzeichnet**,
daß bei den Umsetzerstufen (U1, U2, U3) jeweils der invertierende Eingang Operationsverstärkers (OP) mit einem Anschluß eines sechsten Kondensators (C6) und der Ausgang des Operationsverstärkers (OP) mit einem Anschluß eines siebten Kondensators (C7) verbunden ist und
daß die anderen Anschlüsse von sechstem und siebtem Kondensator (C6, C7) miteinander verbunden und über zwei parallelgeschaltete Schalter (S15, S16), von denen der eine durch das zweite Taktsignal (B) und der andere durch das fünfte Taktsignal (E) gesteuert wird, auf das Bezugspotential aufschaltbar sind.

3. Analog-Digital-Umsetzer nach Anspruch 1 oder 2,
**dadurch gekennzeichnet**,
daß die Impulse von erstem, zweitem und drittem Taktsignal (A, B, C) sich nicht überlappen.

4. Analog-Digital-Umsetzer nach einem der Ansprüche 1 bis 3,
**dadurch gekennzeichnet**,
daß digitale Ausgangssignale (VOD) führende Ausgänge benachbarter Umsetzerstufen (U1, U2, U3) über jeweils eine Differenzierstufe (V1, V2, A2, A3) derart miteinander gekoppelt sind, daß jeweils das Ausgangssignal einer Differenzierstufe (V1, V2, A2, A3) mit dem digitalen Ausgangssignal (VOD) einer Umsetzerstufe (U1, U2, U3) addiert und der jeweils nachfolgenden Differenzierstufe (V1, A2) zugeführt wird.

## Claims

1. Oversampling analogue-to-digital converter comprising at least three identically constructed converter stages (U1, U2, U3) which are respectively triggered by an analogue input signal (VIN) and respectively output an analogue and a digital output signal (VOA; VOD, Q), in which the converter stages (U1, U2, U3) are connected in series with respect to the analogue input and output signals (VIN, VOA), in which the digital output signals (VOD) of the converter stages (U1, U2, U3) are fed and summed up in each case by a number of series-connected differentiating stages (V1, V2, A2, A3) which is equal to the number of the converter stages (U1, U2) respectively connected upstream, in which in the converter stages (U1, U2, U3) respectively have an operational amplifier (OP), at whose output the analogue output signal (VOA) of the respective converter stage (U1, U2, U3) is present, a comparator (KO) connected downstream of the operational amplifier (OP) and- a storage element (FF) which is connected downstream of the comparator (KO) and at whose output the digital output signal (VOD) of the respective converter stage (U1, U2, U3) is present, in which in the converter stages (U1, U2, U3) the analogue input signal (VIN) is respectively fed, on the one hand, via a first controllable switch (S3) to a terminal of a first capacitor (C1) to which, in addition, a first reference potential (VR1) can be applied in series via a second and third controllable switch (S2, S5) and, on the other hand, is fed via a fourth controllable switch (S4) to a terminal of a second capacitor (C2) to which, in addition, a second reference potential (VR2) can be applied via a fifth and sixth controllable switch (S1, S6), in which in the converter stages (U1, U2, U3) the other terminal of the second capacitor (C1) is respectively connected, on the one hand, via a seventh controllable switch (S9) to a reference potential and, on the other hand, via an eighth controllable switch (S7) to a ninth controllable switch (S11), which leads to the reference potential, as well as to a terminal of a third capacitor (C3) whose other terminal is connected to an inverting input of the operational amplifier (OP), in which in the converter stages (U1, U2, U3) the other terminal of the second capacitor (C2) is respectively connected, on the one hand, via a tenth controllable switch (S10) to the reference potential and, on the other hand, via an eleventh controllable switch (S8) to the inverting input of the operational amplifier (OP), in which in the converter stages (U1, U2, U3) the output of the operational amplifier (OP) is respectively connected, on the one hand, via a twelfth controllable switch (S14) and a fourth capacitor (C5) in series to one terminal of the third capacitor (C3) and, on the other hand, via a fifth capacitor (C4) to a thirteenth controllable switch (S12), which leads to the reference potential, and to a fourteenth controllable switch (S13) which is connected to the inverting input of the operational amplifier (OP), in which in the converter stages (U1, U2, U3) the first and fourth switches (S3, S4) are controlled by a first clock signal (A), the sixth, ninth, eleventh and fourteenth switches (S6, S11, S8, S13) are controlled by a second clock signal (B), the third and eighth switches (S5, S7) are controlled by a third clock signal (C), the seventh switch (S9) is controlled by a fourth clock signal (D), the tenth, twelfth and thirteenth switches (S10, S12, S14) are controlled by a fifth clock signal (E), the fifth switch (S1) is controlled by the inverted digital output signal (Q̅), and the second switch (S2) is controlled by the digital output signal (Q), and in which sequentially occurring, cyclically recurring pulses which effect the switching through of the respectively assigned switches are provided as first, second and third clock signal (A, B, C), and pulses which effect the switching through of the respectively assigned switches and start with the pulse of the first clock signal (A) and end with the pulse of the second clock signal (B), or start with the pulse of the third clock signal (C) and end with the pulse of the first clock signal (A) are provided as fourth and fifth clock signal (D, E).

2. Analogue-to-digital converter according to Claim 1, characterized in that in the converter stages (U1, U2, U3) the inverting input of the operational amplifier (OP) is respectively connected to a terminal of a sixth capacitor (C6), and the output of the operational amplifier (OP) is connected to a terminal of a seventh capacitor (C7), and in that the other terminals of the sixth and seventh capacitor (C6, C7) are connected to one another and can have the reference potential applied to them via two parallel-connected switches (S15, S16), of which one is controlled by the second clock signal (B) and the other is controlled by the fifth clock signal (E).

3. Analogue-to-digital converter according to Claim 1 or 2, characterized in that the pulses of the first, second and third clock signal (A, B, C) do not overlap.

4. Analogue-to-digital converter according to one of Claims 1 to 3, characterized in that outputs of adjacent converter stages (U1, U2, U3) carrying digital output signals (VOD) are coupled to one another via a respective differentiating stage (V1, V2, A2, A3) in such a way that in each case the output signal of one differentiating stage (V1, V2, A2, A3) is added to the digital output signal (VOD) of one converter stage (U1, U2, U3) and fed to the respectively following differentiating stage (V1, A2).

## Revendications

1. Convertisseur analogique-numérique à suréchantillonnage, comportant au moins trois étages (U1, U2, U3) convertisseurs, qui sont chacun commandés par un signal (VIN) analogique d'entrée, qui fournissent respectivement des signaux (VO; VOD, Q) analogique et numérique et qui ont une structure identique,
dans lequel les étages (U1, U2, U3) convertisseurs sont branchés en série par rapport aux signaux (VIN, VOA) analogiques d'entrée et de sortie,
dans lequel les signaux (VOD) numériques de sortie des étages (U1, U2, U3) convertisseurs sont fournis et additionnés par l'intermédiaire respectivement de plusieurs étages (V1, V2, A2, A3) différentiateurs branchés en série, dont le nombre est égal à celui des étages (U1, U2) convertisseurs branchés en amont,
dans lequel les étages (U1, U2, U3) convertisseurs comportent chacun un amplificateur (OP) opérationnel, à la sortie duquel est disponible le signal (VOA) analogique de sortie de l'étage (U1, U2, U3) convertisseur considéré, un comparateur (KO) branché en aval de l'amplificateur (OP) opérationnel et un élément (FF) de mémoire, qui est branché en aval du comparateur (KO) et à la sortie duquel est disponible le signal (VOD) numérique de sortie de l'étage (U1, U2, U3) convertisseur considéré,
dans lequel, dans les étages (U1, U2, U3) convertisseurs le signal (VIN) analogique d'entrée est envoyé, d'une part par l'intermédiaire d'un premier interrupteur (S3) commandable à une borne d'un premier condensateur (C1), auquel peut être connecté en outre, par l'intermédiaire de second et troisième interrupteurs (S2, S5) commandables en série, un premier potentiel (VR1) de référence, et d'autre part par l'intermédiaire d'un quatrième interrupteur (S4) commandable à une borne de second condensateur (C2), auquel peut être connecté en outre par l'intermédiaire de cinquième et sixième interrupteurs (S1, S6) commandables, un second potentiel (VR2) de référence,
dans lequel, dans les étages (U1,U2,U3) convertisseurs, l'autre borne du second condensateur (C1) est connectée, d'une part par l'intermédiaire d'un septième interrupteur (S9) commandable à un potentiel de base et d'autre part, par l'intermédiaire d'un huitième interrupteur (S7) commandable à un neuvième interrupteur (S11) commandable menant à ce potentiel de base ainsi qu'à une borne d'un troisième condensateur (C3), dont l'autre borne est reliée à une entrée inverseuse de l'amplificateur (OP) opérationnel,
dans lequel, dans les étages (U1, U2, U3) convertisseurs, l'autre borne du second condensateur (C2) est connectée, d'une part par l'intermédiaire d'un dixième interrupteur (S9) commandable au potentiel de base et d'autre part par l'intermédiaire d'un onzième interrupteur (S8) commandable à l'entrée inverseuse de l'amplificateur (OP) opérationnel, dans lequel, dans les étages (U1, U2, U3) convertisseurs, la sortie de l'amplificateur (OP) opérationnel est connectée, d'une part par l'intermédiaire d'un douzième interrupteur (S14) commandable ainsi que par l'intermédiaire d'un quatrième condensateur (C5), qui est branché en série à l'une des bornes du troisième condensateur (C3), et d'autre part par l'intermédiaire d'un cinquième condensateur (C4), à un treizième interrupteur (S12) commandable menant au potentiel de base, ainsi qu'à un quatorzième interrupteur (S13) commandable connecté à l'entrée inverseuse de l'amplificateur (OP) opérationnel,
dans lequel, dans les étages (U1,U2,U3) convertisseurs, les premier et quatrième interrupteurs (S3, S4) sont commandés par un premier signal (A) de cadence, les sixième, neuvième, onzième et quatorzième interrupteurs (S6, S11, S8, S13) par un second signal (B) de cadence, les troisième et huitième interrupteurs (S5, S7) par un troisième signal (C) de cadence, le septième interrupteur (S9) par un quatrième signal (D) de cadence, les dixième, douzième et treizième interrupteurs (S10, S12, S14) par un cinquième signal (E) de cadence, le cinquième interrupteur (S1) par le signal (`Q) numérique inversé de sortie et le second interrupteur (S2) par le signal (Q) numérique de sortie,
dans lequel il est prévu, comme premier, second et troisième signaux (A, B, C) de cadence, des impulsions, qui apparaissent les unes à la suite des autres, qui réapparaissent cycliquement et qui provoquent la fermeture de l'interrupteur associé considéré et comme quatrième et cinquième signaux (D, E) de cadence, des impulsions, qui provoquent la fermeture de l'interrupteur associé considéré, qui commencent avec l'impulsion du premier signal (A) de cadence et se terminent avec l'impulsion du second signal (B) de cadence ou qui commencent avec l'impulsion du troisième signal (C) de cadence et se terminent avec l'impulsion du premier signal (A) de cadence.

2. Convertisseur analogique-numérique suivant la revendication 1, caractérisé en ce que
dans les étages (U1, U2, U3) convertisseurs, I'entrée inverseuse de l'amplificateur (OP) opérationnel est reliée à une borne d'un sixième condensateur (C6) et la sortie de l'amplificateur (OP) opérationnel est reliée à une borne d'un septième condensateur (C7) et
les autres bornes des sixième et septième condensateurs (C6, C7) sont reliées l'une à l'autre et peuvent être connectées ou potentiel de base par l'intermédiaire de deux interrupteurs (S5, S7) branchés en parallèle, dont l'un est commandé par le second signal (B) de cadence et dont l'autre est commandé par le cinquième signal (E) de cadence.

3. Convertisseur analogique-numérique suivant la revendication 1 ou 2, caractérisé en ce que
les impulsions du premier, du second et du troisième signal (A, B, C) de cadence ne se chevauchent pas.

4. Convertisseur analogique-numérique suivant l'une des revendications 1 à 3, caractérisé en ce que
les sorties d'étages (U1, U2, U3) convertisseurs voisins, fournissant des signaux (VOD) numériques, sont couplées l'une à l'autre par l'intermédiaire respectivement d'un étage différentiateur (V1, V2, A2, A3), de telle sorte que le signal de sortie d'un étage différentiateur (V1, V2, A2, A3) est additionné au signal (VOD) numérique de sortie d'un étage (U1, U2, U3) convertisseur et est envoyé à l'étage (V1, A2) différentiateur branché en aval.
